# FASCICULE DE BREVET EUROPEEN

(11) **EP 3 552 243 B1**
(45) Date de publication et mention de la délivrance du brevet: **19.05.2021**
(21) Numéro de dépôt: 17821685.9
(22) Date de dépôt: 06.12.2017
(51) Int. Cl.: H01L 31/0224, H01L 51/42

(54) **PHOTODÉTECTEUR À COUCHE DE COLLECTE DE PORTEURS DE CHARGE COMPRENANT DES NANOFILS FONCTIONNALISÉS**
LICHTDETEKTOR MIT LADUNGSTRÄGERSAMMELSCHICHT MIT FUNKTIONALISIERTEN NANODRÄHTEN
PHOTODETECTOR WITH CHARGE CARRIER COLLECTION LAYER COMPRISING FUNCTIONALIZED NANOWIRES

(30) Priorité: 08.12.2016 FR 1662165
(43) Date de publication de la demande: 16.10.2019
(73) Titulaire: Commissariat à l'énergie atomique et aux énergies alternatives, 75015 Paris (FR)
(72) Inventeur: BENWADIH, Mohammed, 94500 Champagny sur Marne (FR); HAON, Olivier, 38960 Saint Etienne de Crossey (FR)
(74) Mandataire: Dumont, Alban
(86) Numéro de dépôt international: PCT/FR2017/053418
(87) Numéro de publication internationale: WO 2018/104664

(56) Documents cités:
- WO-A1-2011/106438
- US-A1- 2004 178 325
- US-A1- 2015 083 466
- US-A1- 2015 235 728

## Description

### Domaine de l'invention

L'invention concerne le domaine des photodétecteurs, notamment organiques, et plus particulièrement des électrodes permettant la collecte de porteurs de charge au sein d'une couche active du photodétecteur.

### Etat de la technique

Dans le domaine des photodétecteurs, il existe des photodétecteurs organiques, par exemple des photodiodes organiques, qui sont des systèmes constitués de matériaux semi-conducteurs qui possèdent la faculté de transformer un rayonnement électromagnétique, notamment une énergie lumineuse, en énergie électrique. Cette transformation est due à l'effet photovoltaïque du matériau utilisé qui permet de capter l'énergie des photons reçus pour libérer des porteurs de charge de la bande de valence à la bande de conduction. Ces porteurs de charge, aussi appelés électrons, ou trous, en fonction de la charge associée, peuvent ensuite être collectés par des électrodes correspondantes de sorte à générer de l'énergie électrique.

Dans le cadre des photodiodes organiques, il existe deux architectures respectivement appelées architecture directe ou architecture inverse.

Dans l'architecture directe, la photodiode organique peut être formée par l'empilement suivant formé à partir d'un substrat transparent : une anode destinée à récupérer les trous photogénérés dans une couche active, la couche active et la cathode. L'anode peut comporter une couche de transport de trous en contact avec le substrat et notamment formée en ITO (pour Indium Tin Oxide) et une couche de collecte de trous en PEDOT:PSS qui correspond à poly(3,4-éthylènedioxythiophène) : poly(styrène sulfonate) de sodium.

Dans l'architecture inverse, on retrouve à partir du substrat, l'empilement des éléments successifs suivants à partir du substrat : une cathode comportant une couche de transport d'électrons, notamment en ITO, et une couche de collecte d'électrons, notamment en oxyde de zinc (ZnO) ou en oxyde de titane (TiOx), la couche active, et l'anode comportant une couche de collecte de trous en PEDOT:PSS en contact avec la couche active et une couche de transports de trous.

Le rôle de cette couche de PEDOT:PSS est de réaliser un contact avec la couche active présentant un travail de sortie aligné sur la HOMO (acronyme de « highest occupied molecular orbital » ou bande de conduction en français) du donneur d'électrons. Bien qu'il soit un bon candidat pour collecter des trous, le PEDOT:PSS présente certains inconvénients : il est très sensible au procédé utilisé pour le déposer, en présence d'eau il devient un acide, et il n'est pas homogène car on observe la formation de trous dus à un démouillage lors du dépôt. Par ailleurs, lorsqu'il est déposé sur la couche active (notamment lorsque cette dernière comporte du P3HT et du PCBM), le solvant autorisant le dépôt du PEDOT:PSS dégrade la couche active. Le P3HT est le sigle de poly(3-hexylthiophène), voire poly(3-hexylthiophène-2,5-diyl), il s'agit d'un polymère semiconducteur de type p (donneur d'électrons). Le PCBM est un fullerène, il s'agit préférentiellement du sigle pour [6,6]-phényl-C₆₁-butanoate de méthyle, il s'agit d'un semiconducteur organique de type n (accepteur d'électrons). Un PCBM de type C₆₀ ou C₇₀ peut également être utilisé, l'homme du métier sait choisir le PCBM lorsqu'on lui indique son type. Certains inconvénients liés à l'utilisation du PEDOT:PSS sont décrits dans le document « Stability/degradation of polymer solar cells » de Mikkel Jørgensen et al. Publié dans « Solar Energy Materials & Solar Cells 92 (2008) pages 686-714 ». On comprend donc qu'il existe un besoin de trouver une alternative au PEDOT:PSS en tant que couche de collection de trous au sein d'un photodétecteur.

Par ailleurs, de manière générale, la cathode sera choisie de sorte que son travail de sortie soit aligné sur la LUMO (acronyme de « lowest unoccupied molecular orbital » ou bande de valence en français) de l'accepteur d'électrons.

On comprend de ce qui a été dit ci-dessus que la couche de collecte de trous, et le même principe pour la couche de collecte d'électrons peut s'appliquer aussi, doit préférentiellement satisfaire tout ou partie des conditions/besoins suivants :
- Présenter une conductivité électrique suffisante pour limiter la résistance série du photodétecteur notamment lorsque ce dernier est une diode,
- Présenter un travail de sortie adapté à la couche active utilisée,
- Présenter une stabilité aux conditions de dépôt (compatibilité chimique avec les solvants),
- Présenter une stabilité environnementale par exemple à l'humidité ou à la lumière.

Il en résulte un besoin de développer une électrode destinée à collecter des porteurs de charge et compatible avec la couche active du photodétecteur. Par ailleurs, il existe aussi un besoin de trouver des solutions alternatives à l'existant.

Le document US 2015/0083466 A1 décrit une méthode de fonctionnalisation de nanofils métalliques dans le cadre de la fabrication d'électrodes.

### Objet de l'invention

L'invention a pour but un photodétecteur répondant au moins en partie aux besoins listés ci-dessus.

On tend vers ce but grâce à un photodétecteur comprenant une couche active configurée de sorte à générer des porteurs de charge d'un premier type et d'un deuxième type par absorption d'un rayonnement électromagnétique, une première électrode apte à collecter les porteurs de charge du premier type et une deuxième électrode apte à collecter les porteurs de charge du deuxième type. La première électrode comporte une couche de collecte de porteurs de charge du premier type comprenant : des monocouches auto-assemblées, et des nanofils comportant du métal et fonctionnalisés par lesdites monocouches auto-assemblées de ladite couche de collecte de porteurs de charge du premier type.

Selon la présente invention, les monocouches auto-assemblées de la couche de collecte de porteurs de charge du premier type fonctionnalisent les nanofils de ladite couche de collecte de porteurs de charge du premier type de sorte à modifier le travail de sortie du matériau formant lesdits nanofils.

Selon la présente invention, la couche de collecte de porteurs de charge du premier type comporte du PVDF-TrFe.

Selon une mise en œuvre, les porteurs de charge du premier type sont des trous, et les monocouches auto-assemblées de la couche de collecte de porteurs de charge du premier type comportent du 1H,1H,2H,2H-perfluorodecanethiol, ou du 2H-perfluorooctanethiol, ou du Pentafluorobenzenethiol.

En particulier, les nanofils de la couche de collecte de porteurs de charge du premier type sont des nanofils d'argent, de nickel, d'or, de cuivre ou d'ITO.

Par ailleurs, la deuxième électrode peut comporter une couche de collecte de porteurs de charge du deuxième type comprenant des monocouches auto-assemblées, et des nanofils comportant du métal et fonctionnalisés par lesdites monocouches auto-assemblées de ladite couche de collecte de porteurs de charge du deuxième type.

Selon une réalisation, les porteurs de charge du deuxième type sont des électrons, et les monocouches auto-assemblées de la couche de collecte de porteurs de charge du deuxième type comportent du 2MethylThiophenol ou du 4MethylThiophenol.

Notamment, les nanofils de la couche de collecte de porteurs de charge du deuxième type sont des nanofils d'argent, de nickel, d'or, de cuivre ou d'ITO.

Selon une réalisation, les porteurs de charge du premier type sont des électrons et les monocouches auto-assemblées de la couche de collecte de porteurs de charge du premier type comportent du 2MethylThiophenol ou du 4MethylThiophenol.

L'invention est aussi relative à un procédé de fabrication d'un photodétecteur tel que décrit, ce procédé comporte une étape de fourniture d'une solution comprenant un solvant et destinée à être déposée pour former la couche de collecte de porteurs de charge du premier type, une étape de dépôt de la solution, et une étape de traitement thermique de la solution déposée pour évaporer le solvant.

En particulier, le procédé peut comporter une étape de formation de la couche active, de préférence comportant du P3HT et du PCBM, et la solution est déposée, notamment par sérigraphie, sur la couche active après sa formation, ledit solvant étant choisi parmi l'éthanol, l'isopropanol, le méthoxyéthanol, le méthanol, l'éthylène glycol, le cyclopentanone, et le gamma-butyrolactone, et les monocouches auto-assemblées fonctionnalisant les nanofils de ladite solution comportant du 2H-perfluorooctanethiol, ou du 1H,1H,2H,2H-perfluorodecanethiol, ou du Pentafluorobenzenethiol.

Le procédé peut aussi comporter une étape de préparation de la solution à fournir comprenant les étapes suivantes : une étape de formation d'un mélange comprenant le solvant, des nanofils comportant du métal, un produit destiné à former des monocouches auto-assemblées à la surface des nanofils, une étape de traitement thermique du mélange au cours de laquelle ledit mélange est agité de telle sorte à permettre le greffage du produit sur les nanofils pour former les nanofils fonctionnalisés par des monocouches auto-assemblées.

L'invention est aussi relative à une électrode pour photodétecteur comportant une couche de collecte de porteurs de charge pour, notamment destinée à venir en contact avec, une couche active dudit photodétecteur, ladite couche de collecte de porteurs de charge comportant des nanofils, les nanofils comportant du métal et étant fonctionnalisés par des monocouches auto-assemblées. Les monocouches auto-assemblées de la couche de collecte de porteurs de charge fonctionnalisent les nanofils de ladite couche de collecte de porteurs de charge de sorte à modifier le travail de sortie du matériau formant lesdits nanofils. La couche de collecte de porteurs de charge comporte du PVDF- TrFe.

### Description sommaire des figures

L'invention sera mieux comprise à la lecture de la description qui va suivre, donnée uniquement à titre d'exemple non limitatif et faite en se référant aux dessins sur lesquels :
- La figure 1 illustre schématiquement un photodétecteur selon un mode d'exécution particulier de l'invention,
- La figure 2 illustre schématiquement une portion de la couche de collecte de porteurs de charge du premier type comprenant des nanofils fonctionnalisés par des monocouches auto-assemblées,
- La figure 3 illustre un diagramme de bande,
- La figure 4 illustre schématiquement une portion de la couche de collecte de porteurs de charge du deuxième type comprenant des nanofils fonctionnalisés par des monocouches auto-assemblées,
- La figure 5 illustre schématiquement un photodétecteur équipé de couches de blocage de trous et d'électrons,
- Les figures 6 et 7 illustrent en coupe deux architectures possibles de photodétecteur,
- La figure 8 illustre des étapes d'un procédé permettant de fabriquer un photodétecteur selon un mode d'exécution particulier de l'invention.

Dans ces figures, les mêmes références sont utilisées pour désigner les mêmes éléments.

Par ailleurs, les éléments représentés sur les figures ne sont pas à l'échelle.

### Description de modes particuliers de réalisation

Le photodétecteur décrit ci-après diffère des photodétecteurs de l'art antérieur en ce qu'il propose d'utiliser une couche de collecte de porteurs de charge comprenant des nanofils comportant du métal, lesdits nanofils étant fonctionnalisés par des monocouches auto-assemblées de sorte à adapter le travail de sortie des nanofils à celui de la couche active.

Une couche active au sens de la présente description est une couche permettant de générer des porteurs de charge - par exemple des trous et/ou des électrons - lorsqu'elle est soumise à un rayonnement électromagnétique comme une lumière ou une énergie lumineuse. La couche active peut être organique du fait du matériau qui la compose, ceci étant notamment le cas lorsque le photodétecteur est une photodiode organique.

Une monocouche auto-assemblée - aussi appelée couche monoatomique auto-assemblée - dont la dénomination anglaise classique est SAM pour « Self-assembled Monolayer » peut être formée à partir d'un assemblage de molécules. L'épaisseur de la monocouche auto-assemblée est généralement celle de son assemblage, notamment celle de son assemblage de molécules. En particulier, la SAM peut présenter une épaisseur de l'ordre de 1nm ou allant de 0,3nm à 0,6nm.

Dans la présente description, par transparence d'un élément ou d'une couche à un rayonnement électromagnétique, on entend que cette couche est transparente à ce dernier, notamment à la lumière/énergie lumineuse associée que le photodétecteur peut absorber pour générer des porteurs de charge. Typiquement, on dit que la couche (ou l'élément) est transparente à un rayonnement électromagnétique considéré lorsqu'elle laisse passer plus de 60%, voire plus de 80% de l'énergie de ce rayonnement électromagnétique. En particulier, ici la transparence d'une couche comportant des nanofils fonctionnalisés est conférée par les espaces inter-nanofils, on comprend donc que la densité des nanofils est adaptée en fonction de la transparence souhaitée notamment supérieure ou égale au seuil évoqué ci-dessus. Typiquement, le rayonnement électromagnétique considéré ici est de longueur d'onde comprise entre 150nm et 1500nm. De préférence, dans la description qui va suivre les première et/ou deuxième électrodes sont transparentes au rayonnement électromagnétique destiné à être absorbé par la couche active pour générer des porteurs de charge.

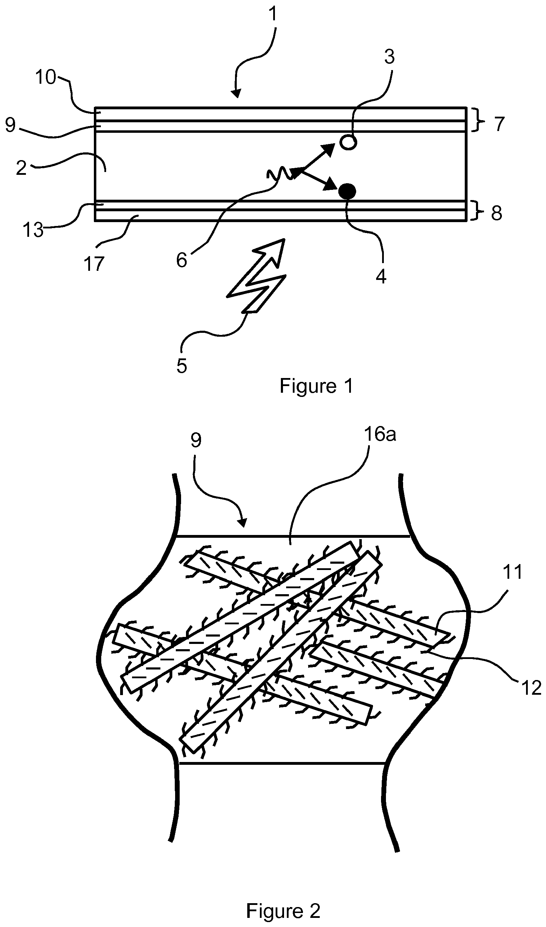

La figure 1 illustre schématiquement un photodétecteur 1, préférentiellement une photodiode notamment organique, comprenant une couche active 2 configurée de sorte à générer des porteurs de charge d'un premier type et d'un deuxième type (3, 4) par absorption du rayonnement électromagnétique 5, notamment de photons 6 issus du rayonnement électromagnétique 5.

La couche active 2 peut, par exemple, être organique. Cette couche active 2 peut comporter un mélange nanostructuré de semi-conducteurs de type p et de type n tel que décrit dans le document « High-efficiency solution processable polymer photovoltaic cells by self-organization of polymer blends » de Li G. et al. Publié dans Nature materials, vol 4, Novembre 2015 pages 864-868. La couche active 2 est préférentiellement en P3HT-PCBM, on dit que la couche active 2 comporte du P3HT et du PCBM ou que la couche active 2 est un mélange de P3HT et de PCBM. La couche active 2 peut aussi être un mélange nanostructuré entre un matériau donneur d'électrons (poly(3-hexylthiophene régio-régulier, connu sous la dénomination P3HT RR) et un matériau accepteur d'électrons (Di[1,4]methanonaphthaleno [1,2:2',3';56,60:2",3"][5,6]fullerene-C60-lh , connu sous la dénomination ICBA ou PCMB de type C60) avec un rapport massique de 1 :2. Selon encore une autre réalisation, cette couche active 2 peut aussi être un mélange nanostructuré entre un matériau donneur d'électrons (Poly[(4,8-bis-(2-ethylhexyloxy)-benzo(1,2-b:4,5-b')dithiophene)-2,6-diyl-alt-(4-(2-thylhexanoyl)-thieno[3,4-b]thiophene-)-2-6-diyl)], connu comme PBDTTT-C) et un matériau accepteur d'électrons ([6,6]-Phenyl-C71-butyric acid methyl ester, connu sous la dénomination de [70]PCBM ou PCBM de type C70 (ce type C70 étant une optimisation du C60 car il est plus stable) avec un rapport massique de 1 :2. Notamment, la couche active 2 présente préférentiellement une épaisseur comprise entre 150nm et 450nm et notamment égale à 300nm. En fait, la couche active 2 est préférentiellement un mélange d'un polymère donneur d'électrons (par exemple le P3HT) et d'un fullerène accepteur d'électrons (par exemple le PCBM).

Par ailleurs, le photodétecteur 1 comporte une première électrode 7 apte à collecter les porteurs de charge du premier type et une deuxième électrode 8 apte à collecter les porteurs de charge du deuxième type. La première électrode 7 comporte une couche de collecte 9 de porteurs de charge du premier type comprenant des monocouches auto-assemblées et des nanofils comportant du métal. Ces nanofils de la couche de collecte 9 de porteurs de charge du premier type 3 sont fonctionnalisés par lesdites monocouches auto-assemblées de ladite couche de collecte 9 de porteurs de charge du premier type. La couche de collecte 9 de porteurs de charge du premier type est préférentiellement en contact avec la couche active 2. Notamment, les monocouches auto-assemblées de la couche de collecte 9 de porteurs de charge du premier type fonctionnalisent les nanofils de ladite couche de collecte 9 de porteurs de charge du premier type de sorte à modifier le travail de sortie du matériau formant lesdits nanofils (c'est à dire modifier le travail de sortie du matériau que comporte lesdits nanofils ou encore modifier le travail de sortie des nanofils), ce matériau comportant au moins le métal visé précédemment. Cette couche de collecte 9 de porteurs de charge du premier type peut être telle que les nanofils fonctionnalisés présentent une densité telle que le critère de transparence de la couche de collecte 9 au rayonnement électromagnétique soit respecté. La première électrode 7 peut aussi comporter une couche de transport 10 de porteurs de charge du premier type, cette couche 10 étant en contact avec la couche de collecte 9 de porteurs de charge du premier type. La présence de cette couche de transport 10 n'est pas nécessaire, elle peut donc être supprimée si besoin par exemple pour limiter les coûts ou éviter certains problèmes de compatibilité entre matériaux. Dans le cas de la présence de la couche de transport 10, cette dernière est telle qu'elle n'est pas en contact direct avec la couche 2. De manière générale, la première électrode 7 est préférentiellement transparente au rayonnement électromagnétique destiné à être absorbé par la couche active 2. La couche de collecte 9 de porteurs de charge du premier type peut présenter une épaisseur comprise entre 10nm et 100nm, et l'épaisseur totale de la première électrode 7 peut être comprise entre 10nm et 100nm.

De manière générale, les porteurs de charge du premier type et du deuxième type sont choisis parmi des électrons 4 et des trous 3. Dans le cas où la première électrode 7 est une anode, les porteurs de charge du premier type sont des trous et les monocouches auto-assemblées de la couche de collecte 9 de porteurs de charge du premier type sont configurées de sorte à augmenter le travail de sortie (pour tendre vers 5.1 eV ou plus) des nanofils de la couche de collecte 9 de porteurs de charge du premier type. Dans le cas où la première électrode 7 est une cathode, les porteurs de charge du premier type sont des électrons 4 et les monocouches auto-assemblées de la couche de collecte 9 de porteurs de charge du premier type sont configurées de sorte à diminuer le travail de sortie (pour tendre vers 4.3 eV ou moins) des nanofils de la couche de collecte 9 de porteurs de charge du premier type.

La figure 2 illustre une portion de la couche de collecte 9 de porteurs de charge du premier type et montre des nanofils 11 fonctionnalisés par des monocouches auto-assemblées 12. La couche de collecte 9 comporte une pluralité de nanofils 11 enchevêtrés et chacun fonctionnalisé par au moins une monocouche auto-assemblée 12 associée. En fait, pour chaque nanofil 11 fonctionnalisé avec au moins une monocouche auto-assemblée 12, on dit que la monocouche auto-assemblée est greffée au métal du nanofil 11 associé. Notamment, chaque nanofil 11 est fonctionnalisé par plusieurs monocouches auto-assemblées 12 qui sont greffées audit nanofil 11. En particulier, les monocouches auto-assemblées 12 fonctionnalisant un nanofil 11 sont telles qu'elles recouvrent la surface totale du nanofil correspondant. Certaines monocouches auto-assemblées peuvent être mises en contact du fait de l'enchevêtrement des nanofils. L'épaisseur de recouvrement d'un nanofil peut être de l'ordre de la somme de ce qui fait partie de la monocouche auto-assemblée et s'étendant depuis le nanofil, notamment il s'agit de la dimension de l'assemblage des molécules de la monocouche auto-assemblée selon la direction correspondante à l'épaisseur de recouvrement.

Dans la présente description, un nanofil est un nano-objet allongé, ou longiligne, notamment obtenu par croissance ou par gravure, il peut présenter une longueur comprise entre 50 nm et 30 µm (notamment de l'ordre de 10 µm) et des dimensions latérales - prises dans un plan de coupe perpendiculaire à l'allongement du nanofil - comprises entre 5 nm et 100 nm (notamment de l'ordre de 10nm).

Dans la présente description, lorsqu'une dimension est associée aux termes « de l'ordre de » on entend exactement cette dimension, ou cette dimension plus ou moins 10%.

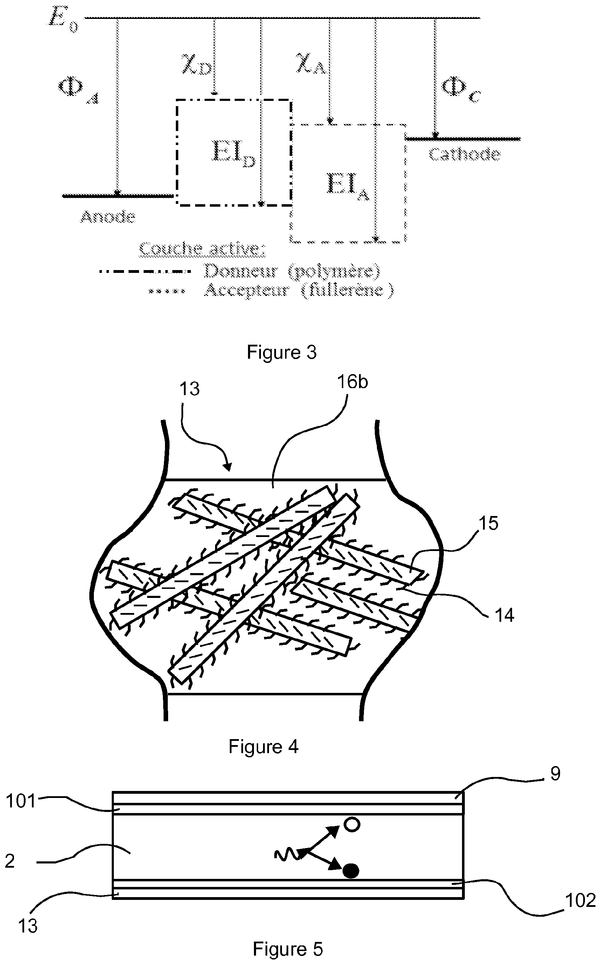

Les nanofils comportant du métal visés dans la présente description peuvent être des nanofils d'argent, d'or, de cuivre, de nickel ou d'ITO (pour Oxyde d'Indium-Etain). Autrement dit, les nanofils comportant du métal peuvent être tels que ledit métal est choisi parmi : l'argent, l'or, le cuivre, le nickel et l'ITO. Seuls, ils présentent un travail de sortie compris entre 4,3 eV et 4,6 eV, ce qui est insuffisant pour garantir le bon fonctionnement du photodétecteur du point de vue électrique. En effet, du côté de l'anode là où on va chercher à collecter les trous, il faut préférentiellement un travail de sortie dont le minimum est de 5,1eV, et du côté de la cathode, là où on va chercher à collecter les électrons il faut un travail de sortie d'au maximum 4,2 eV, ceci étant notamment vrai pour tout type de couche active cité dans la présente description. Autrement dit, la couche active 2 est préférentiellement configurée de sorte que le travail de sortie de l'anode à lui associer soit supérieur ou égal à 5,1eV et que le travail de sortie de la cathode à lui associer soit d'au maximum 4,2eV pour obtenir un bon rendement de collecte des porteurs de charge du premier type et du deuxième type. La figure 3 illustre un diagramme de bande idéal de la structure d'une photodiode composée d'une cathode, du donneur d'électrons, de l'accepteur d'électrons et de l'anode dans lequel la couche active comporte le donneur d'électrons formé par un polymère et l'accepteur d'électrons formé par un fullerène. Sur cette figure 3, le travail de sortie de la cathode et de l'anode est défini comme la différence d'énergie entre le niveau de Fermi du contact (anode ou cathode) et le niveau du vide E₀, Φ_{A} pour l'anode et Φ_{C} pour la cathode. L'affinité électronique du polymère et du fullerène est définie comme la différence d'énergie entre la LUMO et le niveau du vide tandis que leur énergie d'ionisation est définie comme la différence d'énergie entre la HOMO et le niveau du vide. Sur cette figure 3, χ_{A} représente la différence d'énergie entre la LUMO de l'accepteur d'électrons et le niveau du vide, χ_{D} représente la différence d'énergie entre la LUMO du donneur d'électrons et le niveau du vide, EI_{D} représente l'énergie d'ionisation du donneur d'électrons, et EI_{A} représente l'énergie d'ionisation de l'accepteur d'électrons. C'est de ce diagramme qu'il résulte que la couche de collecte des électrons doit préférentiellement présenter un travail de sortie inférieur ou égal à 4,2eV et que la couche de collecte des trous doit préférentiellement présenter un travail de sortie supérieur ou égal à 5,1eV, ceci étant valable pour les couches actives citées dans la présente description.

En choisissant convenablement, notamment les molécules utilisées pour former les monocouches auto-assemblées fonctionnalisant les nanofils, il est possible d'ajuster de manière fine le travail de sortie des nanofils et plus globalement de la couche de collecte 9 de porteurs de charge du premier type.

Dans un premier cas, les porteurs de charge du premier type sont des trous 3 et les monocouches auto-assemblées appartenant à la couche de collecte 9 de porteurs de charge du premier type comportent, c'est-à-dire notamment comportent chacune, du 2H-perfluorooctanethiol (aussi connu sous la dénomination PFOT), ou du Pentafluorobenzenethiol (aussi connu sous la dénomination PFBT), ou du 1H,1H,2H,2H-per-fluorodecanethiol (aussi connu sous la dénomination PFDT). Le PFOT, le PFDT, et le PFBT peuvent être généralisés, le cas échéant, à la famille thiol (R-SH) et à la famille dithiol (HS-R-SH). Les nanofils 11 de la couche de collecte 9 de porteurs de charge du premier type peuvent être tels que décrits précédemment. Pour des nanofils en argent, les monocouches auto-assemblées comportent du, ou sont préférentiellement réalisées en, Pentafluorobenzenethiol de formule C₆HF₅S. On comprend alors que la couche de collecte 9 de porteurs de charge du premier type peut remplacer le PEDOT:PSS communément utilisé dans l'art antérieur, et tout particulièrement dans le cadre d'une architecture inverse où cette couche de collecte 9 de porteurs de charge du premier type est destinée à être formée, notamment par dépôt, sur la couche active 2 tout en évitant de la dégrader comme le ferait du PEDOT:PSS. Pour cela, il est utilisé lors de la formation de la couche de collecte 9 un solvant compatible avec la couche active 2 (en particulier lorsque cette dernière est en, ou comporte du P3HT-PCBM), un tel solvant pouvant être de l'éthanol, de l'isopropanol, du méthoxyéthanol, du méthanol, de l'éthylène glycol, du cyclopentanone, ou du gamma-butyrolactone. En outre, cette couche de collecte 9 de porteurs de charge du premier type est aussi avantageuse dans le sens où elle n'est pas aussi sensible à l'humidité que le PEDOT:PSS, évitant ainsi la formation d'un acide.

Dans un deuxième cas, les porteurs de charge du premier type sont des électrons et les monocouches auto-assemblées de la couche de collecte 9 de porteurs de charge du premier type comportent, c'est à dire notamment comportent chacune, du 2MethylThiophenol (aussi connu sous la dénomination 2MTP) ou du 4MethylThiophenol (aussi connu sous la dénomination 4MTP). Ce deuxième cas permet une alternative au ZnO ou TiOx utilisés dans l'art antérieur. Ceci est avantageux notamment dans le cadre du remplacement du ZnO qui n'est pas stable car présentant une photoconduction et un travail de sortie fonction de l'éclairement qui perturbe la reproductibilité des photodétecteurs. Les nanofils 11 peuvent être en l'un des métaux visés précédemment. Par exemple, pour des nanofils en argent, leur travail de sortie est typiquement compris entre 4,6 eV et 4,7eV, en greffant du 4MTP sur les nanofils en argent, il est possible de former une couche de collecte d'électrons présentant un travail de sortie de l'ordre de 4eV, et en greffant du 2MTP sur les nanofils en argent, il est possible de former une couche de collecte 9 d'électrons présentant un travail de sortie de l'ordre de 3,8eV.

Préférentiellement, dans les premier et deuxième cas, la couche de collecte 9 est réalisée de sorte que la couche de transport 10 ne soit pas en contact avec la couche active 2 car si ce n'est pas le cas, le contact entre la couche de transport 10 et la couche active 2 peut poser des problèmes de transparence et vis à vis du travail de sortie. En ce sens, la couche de collecte 9 peut recouvrir la couche de transport 10 si elle est formée postérieurement à la couche de transport 10.

De manière générale lorsque la couche de transport 10 est présente - sa présence n'étant pas nécessaire - elle est choisie pour être compatible avec la couche de collecte 9. Selon un exemple, dans le cadre du transport de trous la couche de transport 10 peut être en or, en palladium ou en platine, et son épaisseur peut être comprise entre 5nm et 10nm. Selon un autre exemple, dans le cadre du transport d'électrons, la couche de transport 10 peut être en aluminium ou en cuivre, et son épaisseur peut être comprise entre 5nm et 10nm.

Dans les premier et deuxième cas, l'épaisseur de la couche de collecte 9 est préférentiellement d'au maximum 100nm de sorte à conserver une bonne transparence.

Dans un troisième cas, le photodétecteur 1 peut être tel qu'il comporte une couche de collecte de trous à base de nanofils comportant du métal et fonctionnalisés par des monocouches auto-assemblées et une couche de collecte d'électrons à base de nanofils comportant du métal et fonctionnalisés par des monocouches auto-assemblées. Ce troisième cas correspond notamment aux caractéristiques du premier cas associées aux caractéristiques suivantes (figure 1) : la deuxième électrode 8 comporte une couche de collecte 13 de porteurs de charge du deuxième type comprenant des monocouches auto-assemblées 14, et des nanofils 15 (figure 4) comportant du métal et fonctionnalisés par lesdites monocouches auto-assemblées 14 de ladite couche de collecte 13 de porteurs de charge du deuxième type. Dans ce troisième cas, les nanofils de la couche de collecte 13 fonctionnalisés par les monocouches auto-assemblées 14 peuvent l'être à la manière de ce qui a été décrit précédemment en relation avec la figure 2 : autrement dit, la couche de collecte 13 peut comporter une pluralité de nanofils 15 enchevêtrés et chacun fonctionnalisé par au moins une monocouche auto-assemblée 14 associée. En fait, pour chaque nanofil 15 fonctionnalisé avec au moins une monocouche auto-assemblée 14, on dit que la monocouche auto-assemblée 14 est greffée au métal du nanofil 15 associé. Notamment, chaque nanofil 15 est fonctionnalisé par plusieurs monocouches auto-assemblées 14 qui sont greffées audit nanofil 15. En particulier, les monocouches auto-assemblées 14 de la couche de couche de collecte 13 de porteurs de charge du deuxième type fonctionnalisent les nanofils 15 de ladite couche de collecte 13 des porteurs de charge du deuxième type de sorte à modifier le travail de sortie du matériau formant lesdits nanofils 15 (c'est à dire modifier le travail de sortie du matériau que comporte lesdits nanofils ou encore modifier le travail de sortie des nanofils), ce matériau comportant au moins le métal visé précédemment. La couche de collecte 13 de porteurs de charge du deuxième type est préférentiellement en contact avec la couche active 2. Ici, préférentiellement les porteurs de charge du deuxième type sont des électrons et les monocouches auto-assemblées de la couche de collecte 13 de porteurs de charge du deuxième type comportent, c'est à dire notamment comportent chacune, du 2MethylThiophenol ou du 4MethylThiophenol. Dans ce troisième cas, les épaisseurs des couches formant la deuxième électrode peuvent être les mêmes que celles visées pour la première électrode. Par ailleurs, les nanofils comportant du métal peuvent être tels que décrits précédemment. La deuxième électrode 8 peut aussi comporter une couche de transport 17 de porteurs de charge du deuxième type. La présence de cette couche de transport 17 de porteurs de charge du deuxième type n'est pas nécessaire, elle peut donc être supprimée si besoin par exemple pour limiter les coûts ou éviter certains problèmes de compatibilité entre matériaux. De manière générale, lorsque la couche de transport 17 de la deuxième électrode est présente, elle est choisie pour être compatible avec la couche de collecte 13. Selon un exemple, dans le cadre du transport de trous la couche de transport 17 peut être en or, en palladium ou en platine, et son épaisseur peut être comprise entre 5nm et 10nm. Selon un autre exemple, dans le cadre du transport d'électrons, la couche de transport 17 peut être en aluminium ou en cuivre, et son épaisseur peut être comprise entre 5nm et 10nm. Pour les mêmes raisons que ci-dessus, préférentiellement, la couche de collecte 13 est réalisée de sorte que la couche de transport 17 ne soit pas en contact avec la couche active 2.

Concernant la couche de collecte 9 de porteurs de charge du premier type et/ou le cas échéant la couche de collecte 13 de porteurs de charge du deuxième type ces dernières peuvent être formées de différentes manières.

Selon un mode de réalisation, la couche de collecte 9 de porteurs de charge du premier type et/ou le cas échéant la couche de collecte 13 de porteurs de charge du deuxième type comportent seulement des nanofils comportant du métal et fonctionnalisés par des monocouches auto-assemblées correspondantes. Ici, la couche de collecte 9 et/ou la couche de collecte 13 sont préférentiellement directement en contact avec la couche active 2. Bien que ce mode de réalisation soit préféré, il peut engendrer des problèmes d'adhérence de la couche de collecte à la couche active.

Selon un autre mode de réalisation, la couche de collecte 9 et/ou la couche de collecte 13 peuvent comporter un matériau additionnel (référencé 16a pour la couche de collecte 9 à la figure 2 et référencé 16b pour la couche de collecte 13 de la figure 4) permettant de lier les nanofils fonctionnalisés entre eux, notamment par enrobage. Ainsi, de manière applicable aux premier, deuxième ou troisième cas, la couche de collecte 9 de porteurs de charge du premier type et/ou le cas échéant la couche de collecte 13 de porteurs de charge du deuxième type peuvent comporter du PVDF-TrFe 16a, 16b (figures 2 et 4) qui est le sigle de copolymere poly(vinylidene fluoride-trifluoroethylene), il s'agit en fait d'un copolymère. Dans les premier, deuxième ou troisième cas ce copolymère enrobe les nanofils fonctionnalisés. Ce copolymère est particulièrement adapté pour l'enrobage des nanofils fonctionnalisés car il permet, d'une part, un transfert de charges (électrons ou trous) de nanofils à nanofils par mécanisme capacitif et électrostatique, et, d'autre part, de conserver une transparence telle que le rayonnement électromagnétique destiné à générer des porteurs de charge dans la couche active 2 puisse traverser ladite couche de collecte 9 de porteurs de charge du premier type et/ou le cas échéant la couche de collecte 13 de porteurs de charge du deuxième type. Lorsque la couche de collecte 9 de porteurs de charge du premier type est une couche de collecte d'électrons comportant les nanofils fonctionnalisés par lesdites monocouches auto-assemblées, ces nanofils fonctionnalisés peuvent être enrobés/dispersés dans du PCBM : ce matériau est tout particulièrement adapté car il est porteur de charges négatives. Le cas échéant, lorsque la couche de collecte 13 de porteurs de charge du deuxième type est une couche de collecte d'électrons, les nanofils métalliques fonctionnalisés de ladite couche de collecte 13 de porteurs de charge du deuxième type peuvent être enrobés/dispersés dans du PCBM. Lorsque la couche de collecte 9 de porteurs de charge du premier type est une couche de collecte de trous comportant les nanofils fonctionnalisés par lesdites monocouches auto-assemblées, ces nanofils fonctionnalisés peuvent être enrobés/dispersés dans du P3HT : ce matériau est tout particulièrement adapté car il est porteur de charges positives. Le cas échéant, lorsque la couche de collecte 13 de porteurs de charge du deuxième type est une couche de collecte de trous, les nanofils métalliques fonctionnalisés de ladite couche de collecte 13 de porteurs de charge du deuxième type peuvent être enrobés/dispersés dans du P3HT. Un avantage d'utiliser le matériau PCBM au sein de la couche de collecte de porteurs de charge de type électrons (le cas échéant couche 9 ou 13) est que le PCBM va permettre une fonction de blocage des trous pour améliorer la fonction de collecte des électrons. Un avantage d'utiliser le matériau P3HT au sein de la couche de collecte de porteurs de charge de type trous (le cas échéant couche 9 ou 13) est que le P3HT va permettre une fonction de blocage des électrons pour améliorer la fonction de collecte des trous. Préférentiellement, la couche de collecte de porteurs de charge de type électrons peut être telle qu'elle comporte une tranche en PCBM (notamment d'épaisseur comprise entre 5nm et 30nm et préférentiellement égale à 10nm) dépourvue de nanofils fonctionnalisés à son interface avec la couche active 2 : ceci permettant de bloquer plus facilement les trous. Par ailleurs, la couche de collecte de porteurs de charge de type trous peut être telle qu'elle comporte une tranche en P3HT (notamment d'épaisseur comprise entre 5nm et 30nm et préférentiellement égale à 10nm) dépourvue de nanofils fonctionnalisés à son interface avec la couche active 2 : ceci permettant de bloquer plus facilement les électrons.

L'enrobage des nanofils fonctionnalisés, que cela soit dans le cadre de la couche de collecte 9 de porteurs de charge du premier type, ou le cas échéant dans le cadre de la couche de collecte 13 de porteurs de charge du deuxième type, présente un avantage lors de la fabrication du photodétecteur dans le sens où cela permet de séparer les couches et d'éviter qu'un matériau déposé sur ladite couche de collecte concernée vienne fluer entre les nanofils fonctionnalisés.

Selon une mise en œuvre particulière applicable aux différentes réalisations du photodétecteur décrit présentement, le photodétecteur peut comporter (figure 5) une couche de blocage de porteurs de charge du deuxième type 101 interposée entre la couche active 2 et la couche de collecte 9 de porteurs de charge du premier type et/ou une couche de blocage de porteurs de charge du premier type 102 interposée entre la couche de collecte 13 de porteurs de charge du deuxième type et la couche active 2. Notamment, lorsque les porteurs de charge du premier type sont des trous, la couche de blocage des porteurs de charge du deuxième type est une couche de blocage d'électrons, notamment en, ou comportant du, P3HT. Notamment, lorsque les porteurs de charge du deuxième type sont des électrons, la couche de blocage des porteurs de charge du deuxième type est une couche de blocage de trous, notamment en, ou comportant du, PCBM. Les couches de blocage permettent d'améliorer le fonctionnement du dispositif en évitant la collecte de mauvais porteurs de charge au niveau d'une électrode donnée. Notamment, les couches de blocage évoquées ici sont transparentes au rayonnement électromagnétique 5 et présentent une épaisseur de 10nm ou plus généralement comprise entre 2nm et 30nm.

De manière générale, le photodétecteur 1 peut comporter un substrat sur lequel est formée une partie du photodétecteur 1. Ce substrat est typiquement transparent à l'énergie lumineuse, et peut être en verre, en polyéthylène naphtalate (PEN) ou en polyéthylène téréphtalate (PET). Le substrat peut présenter une épaisseur comprise entre 100µm et 125µm.

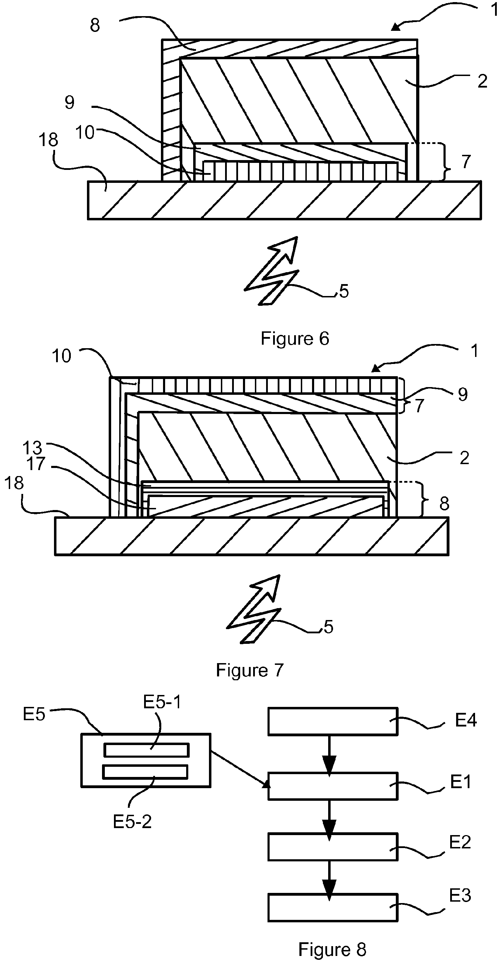

La figure 6 illustre un exemple particulier d'un photodétecteur 1 vue en coupe comprenant un substrat transparent 18 au rayonnement électromagnétique 5 sur lequel est agencé un empilement comportant la première électrode 7, formant alors une anode, munie de sa couche de transport 10 de trous s'étendant depuis le substrat 18, et munie de la couche de collecte 9 de porteurs de charge du premier type (des trous). Préférentiellement, la couche de collecte 9 de trous recouvre la couche de transport de trous 10 de sorte que la couche active 2 ne vienne pas en contact avec la couche de transport 10 de trous. La couche active 2 est alors agencée sur cette première électrode 7 et peut la recouvrir, la couche de collecte 9 de porteurs de charge du premier type étant alors en contact avec cette couche active 2 qui peut s'étendre depuis le substrat 18. Enfin, la deuxième électrode 8, formant une cathode 8 est agencée au moins en partie au sommet de l'empilement. Ici la cathode 8 est représentée en une seule couche mais elle pourrait être formée en plusieurs couches pour, par exemple, comporter la couche de collecte de porteurs de charge du deuxième type telle que précédemment décrite ainsi qu'une couche de transport d'électrons qui préférentiellement ne serait pas en contact avec la couche active 2. Cette architecture est aussi connue sous la dénomination d'architecture directe. Dans ce type d'architecture directe, l'éclairement du photodétecteur 1 se fait par le substrat 18.

La figure 7 illustre un autre exemple particulier d'un photodétecteur 1 vue en coupe comprenant le substrat transparent 18 au rayonnement électromagnétique 5 sur lequel est agencé un empilement comportant la deuxième électrode 8, formant alors une cathode, munie de sa couche de transport d'électrons 17 s'étendant depuis le substrat 18, et muni de la couche de collecte 13 de porteurs de charge du deuxième type (des électrons). Préférentiellement, la couche de collecte 13 d'électrons recouvre la couche de transport d'électrons 17 de sorte que la couche active 2 ne vienne pas en contact avec la couche de transport 17. La couche active 2 est alors agencée sur cette deuxième électrode 8 et peut la recouvrir, la couche de collecte 13 étant alors en contact avec cette couche active 2 qui peut s'étendre depuis le substrat 18. Enfin l'anode 7 est agencée au sommet de l'empilement. Ici l'anode comporte la couche de collecte 9 de porteurs de charge du premier type (à nanofils fonctionnalisés) en contact avec la couche active 2, ainsi que la couche de transport 10 de trous. Ici les couches 9 et 10 sont préférentiellement agencées de telle sorte que la couche 10 ne soit pas en contact avec la couche active 2. Cette architecture est aussi connue sous la dénomination d'architecture inverse. Dans ce type d'architecture inverse, l'éclairement du photodétecteur se fait par le substrat 18.

L'invention est aussi relative à un procédé de fabrication d'un photodétecteur tel que décrit. Notamment le procédé comporte (figure 8) une étape de fourniture E1 d'une solution comprenant un solvant et des nanofils fonctionnalisés par des monocouches auto-assemblées. Cette solution est destinée à être déposée pour former la couche de collecte 9 de porteurs de charge du premier type. On comprend alors que le procédé comporte une étape de dépôt E2 de la solution, puis une étape de traitement thermique E3 de la solution déposée pour évaporer le solvant d'où il résulte l'obtention de la couche de collecte 9 de porteurs de charge telle que décrite. La température appliquée pour le traitement thermique en vue d'évaporer le solvant peut être adaptée par l'homme du métier, il peut s'agir d'un recuit à 120°C par exemple pendant 10min à 30min.

Le procédé peut aussi comporter une étape de formation E4 de la couche active 2, notamment par dépôt. Par ailleurs, les porteurs de charge du premier type étant des trous, l'étape de dépôt E2 de la solution 2 est préférentiellement réalisée sur la couche active 2, notamment en remplacement du PEDOT :PSS de l'art antérieur, il en résulte la formation d'une couche de collecte de trous ne présentant pas les inconvénients de l'art antérieur. Autrement dit, le procédé peut comporter l'étape de formation E4 de la couche active 2, de préférence comportant du P3HT et du PCBM, et la solution est déposée (notamment par sérigraphie ou par enduction) sur la couche active 2 après sa formation, ledit solvant étant choisi parmi l'éthanol, l'isopropanol, le méthoxyéthanol, le méthanol, l'éthylène glycol, le cyclopentanone, et le gamma-butyrolactone, et les monocouches auto-assemblées fonctionnalisant les nanofils de ladite solution comportant, c'est à dire notamment comportant chacune, du 2H-perfluorooctanethiol, ou du 1H,1H,2H,2H-per-fluorodecanethiol, ou du Pentafluorobenzenethiol.

Le procédé peut comporter une étape de préparation E5 de la solution à fournir comprenant les étapes suivantes : une étape de formation E5-1 d'un mélange comprenant le solvant, des nanofils comportant du métal, un produit destiné à former des monocouches auto-assemblées à la surface des nanofils, et une étape de traitement thermique E5-2 du mélange au cours de laquelle ledit mélange est agité de telle sorte à permettre le greffage du produit sur les nanofils pour former les nanofils 11 fonctionnalisés par des monocouches auto-assemblées 12. L'agitation du mélange au cours de l'étape de traitement thermique E5-2 du mélange permet aux nanofils de rester indépendants les uns des autres, en effet, il a été observé qu'en cas d'absence d'agitation du mélange, les nanofils avaient tendance à former des agrégats néfastes pour la future formation de la couche de collecte de porteurs de charge associée. De préférence, pour un volume de 2ml, l'agitation est réalisée à 600rpm (ou 600 tours par minute). Dans le cas où les porteurs de charge du premier type sont des trous, le produit peut comporter du 2H-perfluorooctanethiol, ou du Pentafluorobenzenethiol, ou du 1H,1H,2H,2H-per-fluorodecanethiol (en quantité adaptée pour former des monocouches auto-assemblées) et le solvant peut être choisi parmi l'éthanol, l'isopropanol, le méthoxyéthanol, le méthanol, l'éthylène glycol, le cyclopentanone, et le gamma-butyrolactone. Dans le cas où les porteurs de charge du premier type sont des électrons, le produit peut comporter du 2MTP ou du 4MTP (en quantité adaptée pour former des monocouches auto-assemblées) et le solvant peut être choisi parmi l'éthanol, l'isopropanol, le méthoxyéthanol, le méthanol, l'éthylène glycol, le cyclopentanone, et le gamma-butyrolactone.

Avant de former le mélange, les nanofils peuvent subir un traitement de plasma H₂, ceci permet d'enlever les traces d'oxyde à leurs surfaces pour faciliter par la suite le greffage des monocouches auto-assemblées sur lesdits nanofils.

Notamment, le mélange formé est tel qu'il comporte pour un volume du produit destiné à former les monocouches auto-assemblées mille volumes de solvant. Le nombre de nanofils dans le mélange sera choisi de telle sorte que la future couche de collecte réalisée reste transparente de la manière telle que décrite précédemment. De manière plus générale, on considère qu'il faut 1ml de produit destiné à former les monocouches auto-assemblées pour 1litre de solvant dans le but de réaliser une accroche des monocouches auto-assemblées sans trop de résidu non greffés aux nanofils.

L'étape de traitement thermique E5-2 du mélange pour former la solution à déposer peut comprendre le maintien du mélange à 120°C pendant 1 heure, notamment lorsque les nanofils sont en argent et que le produit est, ou comporte, du pentafluorobenzenethiol. Préférentiellement, lorsque le produit est/comporte du pentafluorobenzenethiol le solvant utilisé est du méthanol ou de l'alcool isopropanol, bien que les autres solvants fonctionnent aussi. En particulier, la température et le temps de mélange sont aussi adaptés pour les différents métaux visés et les différentes SAM visées.

Par ailleurs, avant de déposer la solution, mais après l'étape de traitement thermique E5-2, il peut être rajouté dans la solution le cas échéant le copolymère évoqué ci-dessus, ou le cas échéant du PCBM ou encore du P3HT. Dans le cadre du copolymère de type PVDF-TrFe la solution est constituée par du PVDF-TrFe dans des proportions allant de 1% à 30% en poids de la solution. Le copolymère est alors ajouté après l'étape de traitement thermique avant le dépôt de la solution. De préférence, dans le cadre de l'utilisation du PVDF-TrFe le solvant utilisé pour greffer les monocouches auto-assemblées aux nanofils peut être du cyclopentanone ou du gamma-butyrolactone qui sont aussi des solvants du PVDF-TrFe.

Il a été décrit ci-dessus comment former la couche de collecte 9 de porteurs de charge du premier type à partir d'une solution adaptée. Le même principe peut s'adapter lorsque l'on souhaite former la couche de collecte de porteurs de charge du deuxième type telle que cette dernière comporte aussi des nanofils fonctionnalisés par des monocouches auto-assemblées.

Le procédé décrit peut être mis en œuvre pour former un photodétecteur, notamment une photodiode organique, selon une architecture directe ou une architecture inverse à partir d'un substrat. Notamment, le substrat est transparent à l'énergie de la lumière destinée à être absorbée par la couche active. Le substrat peut être du type tel que décrit précédemment.

Dans l'architecture directe, le procédé peut comporter (figure 6) une étape de fourniture d'un substrat 18 transparent au rayonnement électromagnétique 5 destiné à être absorbé par la couche active 2, une étape de formation de la première électrode 7, transparente au rayonnement électromagnétique 5 destiné à être absorbé par la couche active 2, munie d'une couche de transport de trous 10 en contact avec le substrat 18 et la couche de collecte 9 de porteurs de charge du premier type. Ici, les porteurs de charge du premier type sont des trous et la couche de collecte 9 est formée sur la couche de transport 10 de trous. Ensuite, le procédé peut comporter l'étape de formation de la couche active 2 alors en contact avec la couche de collecte 9 de trous. Enfin, le procédé peut comporter l'étape de formation de la deuxième électrode 8 (formant alors une cathode) sur la couche active 2 déposée préalablement.

Dans l'architecture inverse (figure 7) le procédé peut comporter une étape de fourniture du substrat 18 transparent au rayonnement électromagnétique 5 destiné à être absorbé par la couche active 2, une étape de formation de la deuxième électrode 8, transparente au rayonnement électromagnétique 5 destiné à être absorbée par la couche active 2. Cette deuxième électrode 8 peut comporter une couche de transport 17 d'électrons en contact avec le substrat 18 et la couche de collecte 13 de porteurs de charge du deuxième type. Ici les porteurs de charge du deuxième type sont des électrons et la couche de collecte 13 est formée sur la couche de transport 17 d'électrons. Ensuite, le procédé peut comporter l'étape de formation de la couche active 2 alors en contact avec la couche de collecte 13 d'électrons. Enfin, le procédé peut comporter l'étape de formation de la première électrode 7 sur la couche active 2 déposée préalablement. Cette première électrode 7 pouvant comporter la couche de collecte 9 de porteurs de charge du premier type (trous) telle que décrite ci-avant et déposée directement sur la couche active 2, et enfin la première électrode 7 peut comporter une couche de transport de trous 10 déposée sur la couche de collecte 9 de porteurs de charge du premier type, et par exemple formée en argent.

Il a été généralisé ci-dessus deux variantes de procédé/dispositif à architecture inverse et directe. Selon un exemple particulier, notamment à architecture inverse, le photodétecteur, notamment obtenu selon le procédé décrit précédemment peut comporter un substrat transparent au rayonnement électromagnétique destiné à être absorbé par la couche active (en verre, polyéthylène naphtalate (PEN) ou en polyéthylène téréphtalate (PET)), les première et deuxième électrodes ainsi que la couche active interposée entre les première et deuxième électrodes. Sur ce substrat est formée la deuxième électrode transparente au rayonnement électromagnétique destiné à être absorbé par la couche active (par exemple comprenant une couche en oxyde d'indium dopé à l'étain formant la couche de transport d'électrons, et comprenant une couche de collecte d'électrons, par exemple réalisée en ZnO (oxyde de Zinc) ou PEIE (sigle de Ethoxylated Polyethylenimine) ou TiOx (oxyde de titane). La couche active est alors déposée sur la deuxième électrode. Cette couche active peut par exemple être organique et comporter un mélange nanostructuré de semi-conducteurs de type p et de type n dans ses différentes variantes décrites ci-avant. La première électrode peut être ensuite déposée sur la couche active. La couche active peut être déposée par enduction dans un solvant de type mésytilène, avec une épaisseur sèche de 300nm après recuit thermique permettant l'évaporation du solvant. Cette épaisseur sèche de la couche active permet d'éviter les fuites électriques, c'est-à-dire que cette épaisseur garantie une bonne isolation entre les deux électrodes du photodétecteur. Préférentiellement la couche active s'étend depuis le substrat et recouvre la deuxième électrode notamment sur ses flancs et sur sa face opposée au substrat. La couche active 2 peut aussi être déposée par pulvérisation (« spray coating ») dans un solvant de type chlorobenzène, avec une épaisseur sèche de 800nm après recuit thermique permettant l'évaporation du solvant.

La couche de collecte comprenant les nanofils fonctionnalisés peut être déposée par sérigraphie.

L'invention est aussi relative à une électrode 7, 8 pour photodétecteur comportant une couche de collecte 9, 13 de porteurs de charge pour, notamment destinée à venir en contact avec, une couche active 2 dudit photodétecteur, ladite couche de collecte 9, 13 de porteurs de charge comportant des nanofils fonctionnalisés par des monocouches auto-assemblées.

Dans la présente description, tout ce qui a été dit dans le cadre du procédé ou du photodétecteur peut s'appliquer à l'électrode. Par ailleurs, tout ce qui a été dit dans le cadre du procédé peut s'appliquer au photodétecteur ou inversement.

Ainsi, l'électrode 7, 8 pour photodétecteur 1 peut comporter une couche de collecte 9, 13 de porteurs de charge pour, notamment destinée à venir en contact avec, la couche active 2 dudit photodétecteur 1. Cette couche de collecte 9, 13 de porteurs de charge comportant les nanofils 11, 15 fonctionnalisés par des monocouches auto-assemblées 12, 14. Les monocouches auto-assemblées 12, 14 de la couche de collecte 9, 13 de porteurs de charge fonctionnalisent les nanofils 11, 15 de ladite couche de collecte 9, 13 de porteurs de charge de sorte à modifier le travail de sortie du matériau formant lesdits nanofils 11, 15.

De préférence, la modification du travail de sortie du matériau des nanofils par les monocouches auto-assemblées permet à la couche de collecte de porteurs de charge concernée (premier type, et le cas échéant deuxième type) de présenter un travail de sortie adapté à la couche active 2. Ceci permet de garantir un bon fonctionnement du photodétecteur. En particulier, lorsque le photodétecteur est une photodiode, un décalage du travail de sortie entre l'électrode concernée et la couche active peut provoquer une forte perturbation du photodétecteur pouvant aller jusqu'au court-circuit provoqué par des fuites électroniques. C'est en ce sens, que la couche de collecte 9 de porteurs de charge du premier type de la première électrode 7, et le cas échéant la couche de collecte 13 de porteurs de charge du deuxième type de la deuxième électrode 8, présentent préférentiellement :
- une conductivité électrique suffisante pour limiter la résistance série du photodétecteur notamment lorsque ce dernier est une photodiode,
- un travail de sortie adapté à la couche active,
- une stabilité aux conditions de dépôt utilisées lors de la fabrication du photodétecteur.

## Revendications

1. Photodétecteur (1) comprenant une couche active (2) configurée de sorte à générer des porteurs de charge d'un premier type et d'un deuxième type (3, 4) par absorption d'un rayonnement électromagnétique (5), une première électrode (7) apte à collecter les porteurs de charge du premier type et une deuxième électrode (8) apte à collecter les porteurs de charge du deuxième type, la première électrode (7) comportant une couche de collecte (9) de porteurs de charge du premier type comprenant :
- des monocouches auto-assemblées (12), et
- des nanofils (11) comportant du métal et fonctionnalisés par lesdites monocouches auto-assemblées (12) de ladite couche de collecte (9) de porteurs de charge du premier type,
les monocouches auto-assemblées (12) de la couche de collecte (9) de porteurs de charge du premier type fonctionnalisant les nanofils (11) de ladite couche de collecte (9) de porteurs de charge du premier type de sorte à modifier le travail de sortie du matériau formant lesdits nanofils (11), **caractérisé en ce que** la couche de collecte (9) de porteurs de charge du premier type comporte du PVDF-TrFe (16).

2. Photodétecteur selon la revendication 1, **caractérisé en ce que** les porteurs de charge du premier type sont des trous (3), et **en ce que** les monocouches auto-assemblées de la couche de collecte (9) de porteurs de charge du premier type comportent du 1H,1H,2H,2H-per-fluorodecanethiol, ou du 2H-perfluorooctanethiol, ou du Pentafluorobenzenethiol.

3. Photodétecteur selon l'une quelconque des revendications précédentes, **caractérisé en ce que** les nanofils (11) de la couche de collecte (9) de porteurs de charge du premier type sont des nanofils d'argent, de nickel, d'or, de cuivre ou d'ITO.

4. Photodétecteur selon l'une quelconque des revendications précédentes, **caractérisé en ce que** la deuxième électrode (8) comporte une couche de collecte (13) de porteurs de charge du deuxième type comprenant :
- des monocouches auto-assemblées (14), et
- des nanofils (15) comportant du métal et fonctionnalisés par lesdites monocouches auto-assemblées (14) de ladite couche de collecte (13) de porteurs de charge du deuxième type.

5. Photodétecteur selon la revendication 4, **caractérisé en ce que** les porteurs de charge du deuxième type sont des électrons (4), et **en ce que** les monocouches auto-assemblées (14) de la couche de collecte (13) de porteurs de charge du deuxième type comportent du 2MethylThiophenol ou du 4MethylThiophenol.

6. Photodétecteur selon l'une quelconque des revendications 4 à 5, **caractérisé en ce que** les nanofils (15) de la couche de collecte (13) de porteurs de charge du deuxième type sont des nanofils d'argent, de nickel, d'or, de cuivre ou d'ITO.

7. Photodétecteur selon la revendication 1, **caractérisé en ce que** les porteurs de charge du premier type sont des électrons et les monocouches auto-assemblées de la couche de collecte (9) de porteurs de charge du premier type comportent du 2MethylThiophenol ou du 4MethylThiophenol.

8. Procédé de fabrication d'un photodétecteur (1) selon l'une quelconque des revendications 1 à 7, **caractérisé en ce qu'**il comporte :
- une étape de fourniture (E1) d'une solution comprenant un solvant et destinée à être déposée pour former la couche de collecte (9) de porteurs de charge du premier type,
- une étape de dépôt (E2) de la solution, et
- une étape de traitement (E3) thermique de la solution déposée pour évaporer le solvant.

9. Procédé selon la revendication précédente, **caractérisé en ce qu'**il comporte une étape de formation (E4) de la couche active (2), de préférence comportant du P3HT et du PCBM, et **en ce que** la solution est déposée, notamment par sérigraphie, sur la couche active (2) après sa formation, ledit solvant étant choisi parmi l'éthanol, l'isopropanol, le méthoxyéthanol, le méthanol, l'éthylène glycol, le cyclopentanone, et le gamma-butyrolactone, et les monocouches auto-assemblées fonctionnalisant les nanofils de ladite solution comportant du 2H-perfluorooctanethiol, ou du 1H,1H,2H,2H-per-fluorodecanethiol, ou du Pentafluorobenzenethiol.

10. Procédé selon l'une quelconque des revendications 8 à 9, **caractérisé en ce qu'**il comporte une étape de préparation (E5) de la solution à fournir comprenant les étapes suivantes :
• une étape de formation (E5-1) d'un mélange comprenant le solvant, des nanofils comportant du métal, un produit destiné à former des monocouches auto-assemblées (12) à la surface des nanofils (11),
• une étape de traitement thermique (E5-2) du mélange au cours de laquelle ledit mélange est agité de telle sorte à permettre le greffage du produit sur les nanofils pour former les nanofils (11) fonctionnalisés par des monocouches auto-assemblées (12).

11. Electrode (7, 8) pour photodétecteur (1) comportant une couche de collecte (9, 13) de porteurs de charge pour, notamment destinée à venir en contact avec, une couche active (2) dudit photodétecteur (1), ladite couche de collecte (9, 13) de porteurs de charge comportant des nanofils (11, 15), les nanofils (11, 15) comportant du métal et étant fonctionnalisés par des monocouches auto-assemblées (12, 14), les monocouches auto-assemblées (12, 14) de la couche de collecte (9, 13) de porteurs de charge fonctionnalisant les nanofils (11, 15) de ladite couche de collecte (9,13) de porteurs de charge de sorte à modifier le travail de sortie du matériau formant lesdits nanofils (11, 15), **caractérisée en ce que** la couche de collecte (9, 13) de porteurs de charge comporte du PVDF-TrFe (16).

## Patentansprüche

1. Photodetektor (1), umfassend eine aktive Schicht (2), auf eine Weise konfiguriert, um Ladungsträger einer ersten Art und einer zweiten Art (3, 4) durch Absorption einer elektromagnetischen Strahlung (5) zu erzeugen, eine erste Elektrode (7), geeignet, um die Ladungsträger der ersten Art zu sammeln und eine zweite Elektrode (8), geeignet, um die Ladungsträger der zweiten Art zu sammeln, wobei die erste Elektrode (7) eine Sammelschicht (9) von Ladungsträgern der ersten Art beinhaltet, umfassend:
- selbstorganisierte Einzelschichten (12), und
- Nanodrähte (11), beinhaltend Metall und funktionalisiert durch die selbstorganisierten Einzelschichten (12) der Sammelschicht (9) von Ladungsträgern der ersten Art,
wobei die selbstorganisierten Einzelschichten (12) der Sammelschicht (9) von Ladungsträgern der ersten Art die Nanodrähte (11) der Sammelschicht (9) von Ladungsträgern der ersten Art auf eine Weise funktionalisieren, um die Austrittsarbeit des Materials, das die Nanodrähte (11) bildet, zu modifizieren, **dadurch gekennzeichnet, dass** die Sammelschicht (9) von Ladungsträgern der ersten Art PVDF-TrFe (16) beinhaltet.

2. Photodetektor nach Anspruch 1, **dadurch gekennzeichnet, dass** die Ladungsträger der ersten Art Löcher (3) sind, und dadurch, dass die selbstorganisierten Einzelschichten der Sammelschicht (9) von Ladungsträgern der ersten Art 1H,1H,2H,2H-Perfluordecanthiol oder 2H-Perfluoroctanthiol oder Pentafluorbenzolthiol beinhalten.

3. Photodetektor nach einem der vorstehenden Ansprüche, **dadurch gekennzeichnet, dass** die Nanodrähte (11) der Sammelschicht (9) von Ladungsträgern der ersten Art Nanodrähte aus Silber, Nickel, Gold, Kupfer oder ITO sind.

4. Photodetektor nach einem der vorstehenden Ansprüche, **dadurch gekennzeichnet, dass** die zweite Elektrode (8) eine Sammelschicht (13) von Ladungsträgern der zweiten Art beinhaltet, umfassend:
- selbstorganisierte Einzelschichten (14) und
- Nanodrähte (15), beinhaltend Metall und funktionalisiert durch die selbstorganisierten Einzelschichten (14) der Sammelschicht (13) von Ladungsträgern der zweiten Art.

5. Photodetektor nach Anspruch 4, **dadurch gekennzeichnet, dass** die Ladungsträger der zweiten Art Elektronen (4) sind, und dadurch, dass die selbstorganisierten Einzelschichten (14) der Sammelschicht (13) von Ladungsträgern der zweiten Art 2MethylThiophenol oder 4MethylThiophenol beinhalten.

6. Photodetektor nach einem der Ansprüche 4 bis 5, **dadurch gekennzeichnet, dass** die Nanodrähte (15) der Sammelschicht (13) von Ladungsträgern der zweiten Art Nanodrähte aus Silber, Nickel, Gold, Kupfer oder ITO sind.

7. Photodetektor nach Anspruch 1, **dadurch gekennzeichnet, dass** die Ladungsträger der ersten Art Elektronen sind und die selbstorganisierten Einzelschichten der Sammelschicht (9) von Ladungsträgern der ersten Art 2MethylThiophenol oder 4MethylThiophenol beinhalten.

8. Herstellungsverfahren eines Photodetektors (1) gemäß einem der Ansprüche 1 bis 7, **dadurch gekennzeichnet, dass** es beinhaltet:
- einen Schritt des Bereitstellens (E1) einer Lösung, umfassend ein Lösemittel und bestimmt, zum Bilden der Sammelschicht (9) von Ladungsträgern der ersten Art abgeschieden zu werden,
- einen Schritt des Abscheidens (E2) der Lösung, und
- einen Schritt der thermischen Behandlung (E3) der abgeschiedenen Lösung, um das Lösemittel zu verdampfen.

9. Verfahren nach dem vorstehenden Anspruch, **dadurch gekennzeichnet, dass** es einen Schritt der Bildung (E4) der aktiven Schicht (2), vorzugsweise beinhaltend P3HT und PCBM, beinhaltet, und dadurch, dass die Lösung nach ihrer Bildung insbesondere durch Siebdruck auf die aktive Schicht (2) abgeschieden wird, wobei das Lösemittel ausgewählt ist aus Ethanol, Isopropanol, Methoxyethanol, Methanol, Ethylenglycol, Cyclopentanon, gamma-Butyrolacton, und die selbstorganisierten Einzelschichten, die die Nanodrähte der Lösung funktionalisieren, 2H-Perfluoroctanthiol oder 1H,1H,2H,2H-Perfluordecanthiol oder Pentafluorbenzolthiol beinhalten.

10. Verfahren nach einem der Ansprüche 8 bis 9, **dadurch gekennzeichnet, dass** es einen Schritt der Zubereitung (E5) der bereitzustellenden Lösung beinhaltet, umfassend die folgenden Schritte:
• einen Schritt der Bildung (E5-1) eines Gemisches, umfassend das Lösemittel, Metall beinhaltende Nanodrähte, ein Produkt, bestimmt, um die selbstorganisierten Einzelschichten (12) an der Oberfläche der Nanodrähte (11) zu bilden,
• einen Schritt der thermischen Behandlung (E5-2) des Gemisches, im Laufe dessen das Gemisch derart gerührt wird, um die Pfropfung des Produkts auf die Nanodrähte zum Bilden der durch die selbstorganisierten Einzelschichten (12) funktionalisierten Nanodrähte (11) zu gestatten.

11. Elektrode (7, 8) für Photodetektor (1), beinhaltend eine Sammelschicht (9, 13) von Ladungsträgern, insbesondere bestimmt, um mit einer aktiven Schicht (2) des Photodetektors (1) in Kontakt zu kommen, wobei die Sammelschicht (9, 13) von Ladungsträgern Nanodrähte (11, 15) beinhaltet, wobei die Nanodrähte (11, 15) Metall beinhalten und durch selbstorganisierte Einzelschichten (12, 14) funktionalisiert sind, wobei die selbstorganisierten Einzelschichten (12, 14) der Sammelschicht (9, 13) von Ladungsträgern die Nanodrähte (11, 15) der Sammelschicht (9, 13) von Ladungsträgern auf eine Weise funktionalisiert, um die Austrittsarbeit des Materials, das die Nanodrähte (11, 15) bildet, zu modifizieren, **dadurch gekennzeichnet, dass** die Sammelschicht (9, 13) von Ladungsträgern PVDF-TrFe (16) beinhaltet.

## Claims

1. A photodetector (1) comprising an active layer (2) configured so as to generate charge carriers of a first type and of a second type (3, 4) by absorption of electromagnetic radiation (5), a first electrode (7) capable of collecting charge carriers of the first type and a second electrode (8) capable of collecting charge carriers of the second type, the first electrode (7) including a collection layer (9) of charge carriers of the first type comprising:
- self-assembled monolayers (12), and
- nanowires (11) including metal and functionalized by said self-assembled monolayers (12) of said collection layer (9) of charge carriers of the first type,
the self-assembled monolayers (12) of the collection layer (9) of charge carriers of the first type functionalizing the nanowires (11) of said collection layer (9) of charge carriers of the first type so as to modify the work function of the material forming said nanowires (11), **characterized in that** the collection layer (9) of charge carriers of the first type includes PVDF-TrFe (16).

2. The photodetector according to claim 1, **characterized in that** the charge carriers of the first type are holes (3), and **in that** the self-assembled monolayers of the collection layer (9) of charge carriers of the first type include 1H,1H,2H,2H-perfluorodecanethiol, or 2H-perfluorooctanethiol, or Pentafluorobenzenethiol.

3. The photodetector according to any one of the preceding claims, **characterized in that** the nanowires (11) of the collection layer (9) of charge carriers of the first type are nanowires of silver, nickel, gold, copper or ITO.

4. The photodetector according to any one of the preceding claims, **characterized in that** the second electrode (8) includes a collection layer (13) of charge carriers of the second type comprising:
- self-assembled monolayers (14), and
- nanowires (15) including metal and functionalized by said self-assembled monolayers (14) of said collection layer (13) of charge carriers of the second type.

5. The photodetector according to claim 4, **characterized in that** the charge carriers of the second type are electrons (4), and **in that** the self-assembled monolayers (14) of the collection layer (13) of charge carriers of the second type include 2MethylThiophenol or 4MethylThiophenol.

6. The photodetector according to any one of claims 4 to 5, **characterized in that** the nanowires (15) of the collection layer (13) of charge carriers of the second type are nanowires of silver, nickel, gold, copper or ITO.

7. The photodetector according to claim 1, **characterized in that** the charge carriers of the first type are electrons and the self-assembled monolayers of the collection layer (9) of charge carriers of the first type comprise 2MethylThiophenol or 4MethylThiophenol.

8. A method for manufacturing a photodetector (1) according to any one of claims 1 to 7, **characterized in that** it includes:
- a step of supplying (E1) a solution comprising a solvent and intended to be deposited to form the collection layer (9) of charge carriers of the first type,
- a step of depositing (E2) the solution, and
- a step (E3) of thermal treating the deposited solution in order to evaporate the solvent.

9. The method according to the preceding claim, **characterized in that** it includes a step of forming (E4) the active layer (2), preferably including P3HT and PCBM, and **in that** the solution is deposited, in particular by screen printing, on the active layer (2) after its formation, said solvent being selected from ethanol, isopropanol, methoxyethanol, methanol, ethylene glycol, cyclopentanone, and gamma-butyrolactone, and self-assembled monolayers functionalizing the nanowires of said solution including 2H-perfluorooctanethiol, or 1H,1H,2H,2H-perfluorodecanethiol, or Pentafluorobenzenethiol.

10. The method according to any one of claims 8 to 9, **characterized in that** it includes a step of preparing (E5) the solution to be provided comprising the following steps:
• a step of forming (E5-1) a mixture comprising the solvent, nanowires including metal, a product intended to form self-assembled monolayers (12) on the surface of the nanowires (11),
• a step of thermal treating (E5-2) the mixture during which said mixture is stirred so as to allow the grafting of the product on the nanowires to form the nanowires (11) functionalized by self-assembled monolayers (12).

11. An electrode (7, 8) for a photodetector (1) including a collection layer (9, 13) of charge carriers for, in particular intended to come into contact with, an active layer (2) of said photodetector (1), said charge carrier collection layer (9, 13) including nanowires (11, 15), the nanowires (11, 15) including metal and being functionalized by self-assembled monolayers (12, 14), the self-assembled monolayers (12, 14) of the charge carrier collection layer (9, 13) functionalizing the nanowires (11, 15) of said charge carrier collection layer (9,13) so as to modify the work function of the material forming said nanowires (11, 15), **characterized in that** the charge carrier collection layer (9, 13) includes PVDF-TrFe (16).
